# EUROPEAN PATENT APPLICATION

(11) **EP 4 016 842 A1**
(43) Date of publication of application: **22.06.2022**
(21) Application number: 20853187.1
(22) Date of filing: 24.04.2020
(51) Int. Cl.: H03H 9/02

(54) **BULK ACOUSTIC RESONATOR WITH CENTRAL DEFECT STRUCTURE, FILTER AND ELECTRONIC DEVICE**

(30) Priority: 15.08.2019 CN 201910751462
(71) Applicant: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/086566
(87) International publication number: WO 2021/027321

(57) **Abstract**

The present invention relates to a bulk acoustic resonator, including a substrate, an acoustic lens, a bottom electrode, a top electrode, and a piezoelectric layer, wherein an overlapped region of the acoustic lens, the bottom electrode, the piezoelectric layer and the top electrode in the thickness direction of the substrate is an effective region of the resonator; a central defect structure is formed in the effective region; in a top view of the resonator, at least a part of the central defect structure is located in a high-temperature region of the effective region; the high-temperature region is an region with the center of mass of the effective region as the center of a circle and r as the radius, the radius r is 50% of the radius of an equivalent circle of the effective region where the high-temperature region is located, and the equivalent circle is a circle with the center of mass of the effective region as the center of a circle and the area of the circle equal to the area of the effective region. The present invention also relates to a filter and an electronic device.

## Description

### TECHNICAL FIELD

Embodiments of the present disclosure relate to the field of semiconductors, and in particular, to a bulk acoustic wave resonator, a filter, and an electronic device having one of the bulk acoustic wave resonator and the filter.

### BACKGROUND

A Film Bulk Acoustic Resonator (FBAR, also referred to as a Bulk Acoustic Wave Resonator (BAW)) is very important in the field of communication when used as a MEMS chip. The traditional surface acoustic wave (SAW) filters and ceramic filters are gradually replaced by the FBAR filters due to their small size (µm level), high resonant frequency (GHz), high quality factor (1000), large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The film bulk acoustic resonator mainly includes a "sandwich" structure composed of electrode-piezoelectric film-electrode, i.e., the piezoelectric film is sandwiched between the two metal electrodes. When a sinusoidal signal is input between the two electrodes, the FBAR converts an input electrical signal into a mechanical resonance through an inverse piezoelectric effect, and then converts the mechanical resonance into an electrical signal output through a piezoelectric effect. The film bulk acoustic resonator mainly utilizes a longitudinal piezoelectric coefficient (d33) of the piezoelectric film to generate the piezoelectric effect, and thus mainly operates in a thickness extensional (TE) mode in a thickness direction.

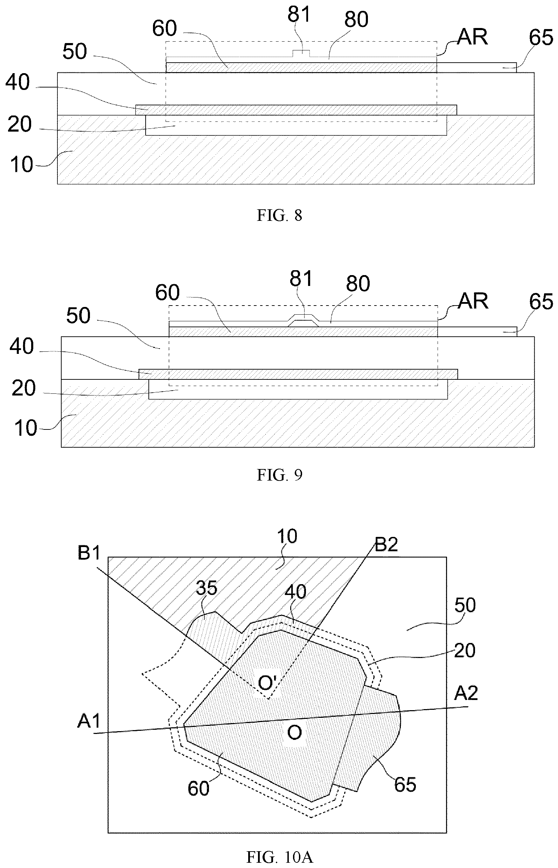

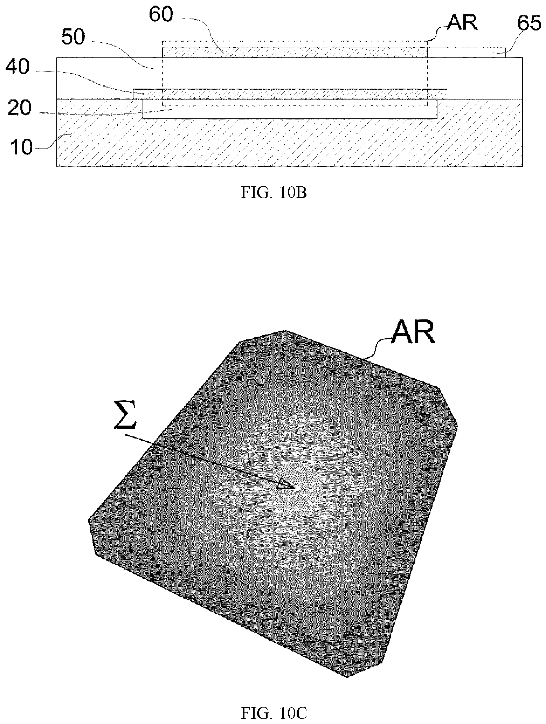

FIG. 10A is a top view of a bulk acoustic wave resonator in the related art, and FIG. 10B is a sectional view along line A1-O-A2 in FIG. 10A. As shown in FIGS. 10A-10B, a part of a piezoelectric layer 50 above a polyline B1-O'-B2 such that a portion of a bottom electrode 40, a bottom electrode pin 35 and a substrate 10 are exposed in the top view. The details of each part are described as follows:
10: a substrate typically made of monocrystalline silicon, gallium arsenide, sapphire, quartz and the like.
20: an acoustic mirror which may be an air cavity in the above embodiment and may employ a Bragg reflection layer or other equivalent acoustic reflection structures.
40(35)/60(65): a bottom electrode (pin)/a top electrode (pin) made of molybdenum, ruthenium, gold, aluminum, magnesium, tungsten, copper, titanium, iridium, osmium, chromium, or composites or alloys thereof.
50: a piezoelectric layer film made of aluminum nitride, zinc oxide, PZT and the like and containing rare earth element doping materials with the above materials of a predetermined atomic ratio.

FIG. 10C shows a schematic diagram of a temperature gradient distribution of an effective region AR of the resonator in FIG. 10A, in which dark regions represent low temperature, bright regions represent high temperature, and a highest temperature point is located at a position denoted by Σ.

When the above resonator operates, a part of the acoustic vibration energy and electric energy are inevitably converted into heat energy. As the resonator power increases, a heat generation problem becomes prominent increasingly, resulting in an excessively high operating temperature of the resonator. The high temperature not only adversely affects frequency characteristics of the resonator, but also accelerates aging and damage to various components of the resonator. The heat generation problem is especially serious in a central region of the effective region of the resonator.

### SUMMARY

In the present disclosure, there is provided a defect-type power enhancement structure that is located at or near a center of an effective acoustic region of a bulk acoustic wave resonator in a top view thereof. The structure allows a vibration frequency at or near a highest temperature point in the resonator to deviate from a resonance point, thereby reducing a temperature of the resonator.

According to an aspect of embodiments of the present disclosure, there is provided a bulk acoustic wave resonator. The bulk acoustic wave resonator includes a substrate, an acoustic mirror, a bottom electrode, a top electrode, and a piezoelectric layer. The acoustic mirror, the bottom electrode, the piezoelectric layer and the top electrode overlap with each other in a thickness direction of the resonator to form an overlapping region, which is an effective region of the resonator. A central defect structure is provided in the effective region, and in a top view of the resonator, at least part of the central defect structure is located in a high-temperature region of the effective region, the high-temperature region refers to a region that is centered on a center of mass of the effective region and has a radius r, the radius r is 50%, alternatively 20% of a radius of an equivalent circle of the effective region where the high-temperature region is located, and the equivalent circle is centered on the center of mass of the effective region and has an area equal to an area of the effective region.

Alternatively, the central defect structure includes an arched structure or a recessed structure integrated with the top electrode or the bottom electrode. Alternatively, the arched structure is configured to form a gap between the top electrode or the bottom electrode and the piezoelectric layer, and the recessed structure is configured to form a recess on a side of the top electrode or the bottom electrode away from the piezoelectric layer. Alternatively, a portion of the top electrode or the bottom electrode for forming the arched structure or the recessed structure has a thickness same as thicknesses of other portions.

Alternatively, the gap has a thickness in a range of 20 Å to 20000 Å, or the recess has a depth in a range of 20 Å to 20000 Å.

Alternatively, the gap or the recess is filled with air, a dielectric material, or a metal oxide.

Alternatively, the gap or the recess is filled with a metal, and the metal has a density greater than a density of a material of the top electrode or the bottom electrode where the gap or the recess is located.

Alternatively, the central defect structure is an electrode filling structure arranged in the top electrode or the bottom electrode, and the electrode filling structure is made of a metal and the metal has a density greater than a density of a material of the top electrode or the bottom electrode. Alternatively, the electrode filling structure is arranged in a through hole of the top electrode or the bottom electrode, and is flush with the electrode where the electrode filling structure is located.

Alternatively, the central defect structure is a metal protrusion arranged on the top electrode or the bottom electrode, and the metal protrusion protrudes from one side of the respective electrode.

Alternatively, the central defect structure is a piezoelectric layer filling structure arranged in the piezoelectric layer. Alternatively, the piezoelectric layer filling structure at least partially extends in a thickness direction of the piezoelectric layer. Alternatively, the piezoelectric layer filling structure is arranged in a through hole of the piezoelectric layer, and is connected with the top electrode and the bottom electrode.

Alternatively, the piezoelectric layer filling structure is made of a material selected from air or a non-piezoelectric and non-conductive material. Alternatively, the non-piezoelectric and non-conductive material includes silicon dioxide, silicon nitride, silicon carbide, aluminum oxide, or magnesium oxide.

Alternatively, the resonator further includes an auxiliary layer provided on the top electrode. The central defect structure includes an arched structure, a recessed structure or a protruding structure integrated with the auxiliary layer, or a filling structure provided in the auxiliary layer.

Alternatively, in a top view of the resonator, the central defect structure has a circle or square shape, or a polygonal shape similar to a shape of the effective region. Alternatively, in the top view of the resonator, the central defect structure has a maximum dimension, and the maximum dimension is in a range of 1 µm to 50 µm or within 20% of a length of a longest side of the effective region of the polygonal resonator. Alternatively, in the top view of the resonator, the maximum dimension of the central defect structure is in a range of 1 µm to 50 µm or within 5% of the length of the longest side of the effective region of the polygonal resonator.

According to another aspect of embodiments of the present disclosure, there is provided a bulk acoustic wave resonator. The bulk acoustic wave resonator includes a substrate, an acoustic mirror, a bottom electrode, a top electrode, and a piezoelectric layer. The acoustic mirror, the bottom electrode, the piezoelectric layer and the top electrode overlap with each other in a thickness direction of the resonator to form an overlapping region, which is an effective region of the resonator. A central defect structure is provided in the effective region. In a top view of the resonator, the central defect structure is located in at least part of a high-temperature region, a thickness of the central defect structure is the same as or different from a thickness of a layer where the central defect structure is located and/or a material of the central defect structure is the same as or different from a material of the layer, the high-temperature region refers to a region that is centered on a center of mass of the effective region and has a radius r, the radius r is 50% of a radius of an equivalent circle of the effective region where the high-temperature region is located, and the equivalent circle is centered on the center of mass of the effective region and has an area equal to an area of the effective region.

Alternatively, the central defect region is arranged within the high-temperature region in the present disclosure.

According to a further another aspect of embodiments of the present disclosure, there is provided a filter that includes the bulk acoustic wave resonator as described above.

According to a yet another aspect of embodiments of the present disclosure, there is provided an electronic device that includes the bulk acoustic wave resonator as described above or the filter as described above.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1A is a schematic sectional view of a bulk acoustic wave resonator according to an exemplary embodiment of the present disclosure;
FIG. 1B is a schematic view of a central defect structure in FIG. 1A according to an exemplary embodiment of the present disclosure;
FIG. 1C is a schematic view of the central defect structure in FIG. 1A according to another exemplary embodiment of the present disclosure;
FIG. 1D is a schematic view of shapes of the central defect structure and an effective region in FIG. 1A according to yet another exemplary embodiment of the present disclosure;
FIG. 1E is a schematic dimensional view of the central defect structure in FIG. 1A according to an exemplary embodiment of the present disclosure;
FIG. 2 is a schematic sectional view of a bulk acoustic wave resonator according to an exemplary embodiment of the present disclosure;
FIG. 3 is a schematic sectional view of a bulk acoustic wave resonator according to an exemplary embodiment of the present disclosure;
FIG. 4 is a schematic sectional view of a bulk acoustic wave resonator according to an exemplary embodiment of the present disclosure;
FIG. 5 is a schematic sectional view of a bulk acoustic wave resonator according to an exemplary embodiment of the present disclosure;
FIG. 6 is a schematic sectional view of a bulk acoustic wave resonator according to an exemplary embodiment of the present disclosure;
FIG. 7 is a schematic sectional view of a bulk acoustic wave resonator according to an exemplary embodiment of the present disclosure;
FIG. 8 is a schematic sectional view of a bulk acoustic wave resonator according to an exemplary embodiment of the present disclosure;
FIG. 9 is a schematic sectional view of a bulk acoustic wave resonator according to an exemplary embodiment of the present disclosure;
FIG. 10A is a top view of a bulk acoustic wave resonator in the related art;
FIG. 10B is a sectional view along line A1-O-A2 in FIG. 10A; and
FIG. 10C is a schematic diagram of a temperature gradient distribution of an effective region AR of the resonator in FIG. 10A, in which dark regions represent low temperature, bright regions represent high temperature, and a highest temperature point is located at a position denoted by Σ.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

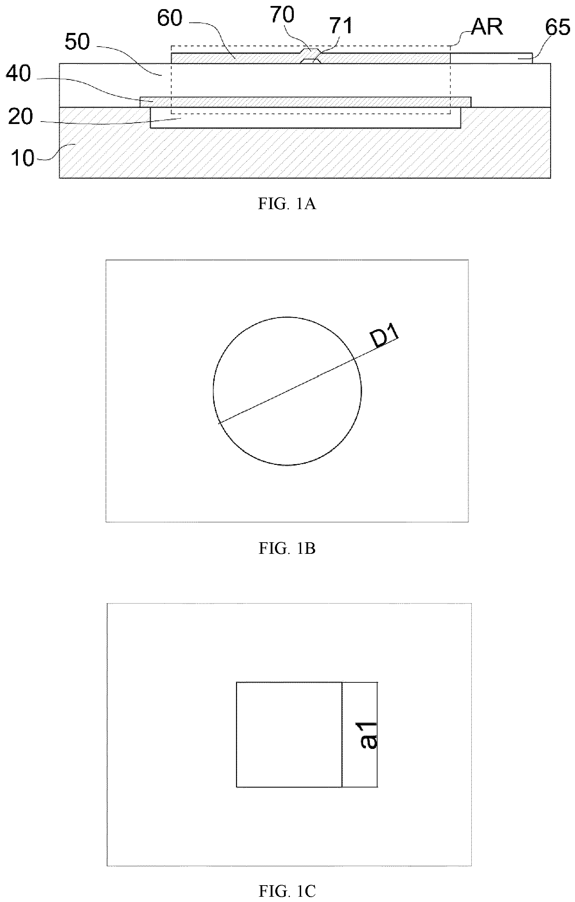

FIG. 1A is a schematic sectional view of a bulk acoustic wave resonator according to an exemplary embodiment A100 of the present disclosure.

The bulk acoustic wave resonator includes:
10: a substrate typically made of monocrystalline silicon, gallium arsenide, sapphire, quartz or the like;
20: an acoustic mirror which is an air cavity in the above embodiment, or may employ a Bragg reflection layer or other equivalent acoustic reflection structures;
40(35)/60(65): a bottom electrode (pin)/a top electrode (pin) made of molybdenum, ruthenium, gold, aluminum, magnesium, tungsten, copper, titanium, iridium, osmium, chromium, or composites or alloys thereof; and
50: a piezoelectric layer film made of aluminum nitride, zinc oxide, PZT or the like and containing rare earth element doping materials with the above materials of a predetermined atomic ratio.

In the embodiment A100, the bulk acoustic wave resonator further includes an arched structure 70 near a center of the top electrode, and the arched structure 70 is separated from the piezoelectric layer 50 therebelow so that a gap 71 is formed between the arched structure 70 and the piezoelectric layer 50. The gap 71 may be a void or filled with dielectric materials such as silicon dioxide, silicon nitride, silicon carbide, various metal oxides (for example, aluminum oxide, magnesium oxide or the like), or heavy metal materials (for example, gold, platinum, iridium, osmium, tungsten or the like). The heavy metal filled in the gap 71 may have a density greater than that of a surrounding electrode material.

When a non-metallic material (including air) is filled, an excitation electric field exerted to the aluminum nitride under the arched structure is weakened and thus vibration of the piezoelectric layer is reduced. In this way, a thermal power of a central region with the highest temperature is decreased accordingly, and thus a temperature of the central region of the resonator is decreased.

When a heavy metal is filled, the electric field under the arched structure 70 will not be weakened or eliminated. However, since the density of the filled metal is greater than that of the surrounding electrode material, a significant mass load is formed by the filled metal in an effective acoustic region, which is covered by the arched structure 70 and the heavy metal therebelow. This load can reduce amplitude of a local region where the arched structure 70/gap 71 is located and deviate a frequency in this region from a resonance point of a surrounding acoustic region, thereby reducing the temperature of the central region of the resonator.

FIG. 1B is a schematic view of the central defect structure in FIG. 1A according to an exemplary embodiment of the present disclosure. FIG. 1C is a schematic view of the central defect structure in FIG. 1A according to another exemplary embodiment of the present disclosure.

The central defect structure may be formed into a circle shape as shown in 1B, which has a diameter D1 in a range of 1 µm to 50 µm, preferably in a range of 1 µm to 10 µm. The central defect structure may be formed into a square shape as shown in FIG. 1C, which has a side length a1 in a range of 1 µm to 50 µm, preferably in a range of 1 µm to 10 µm.

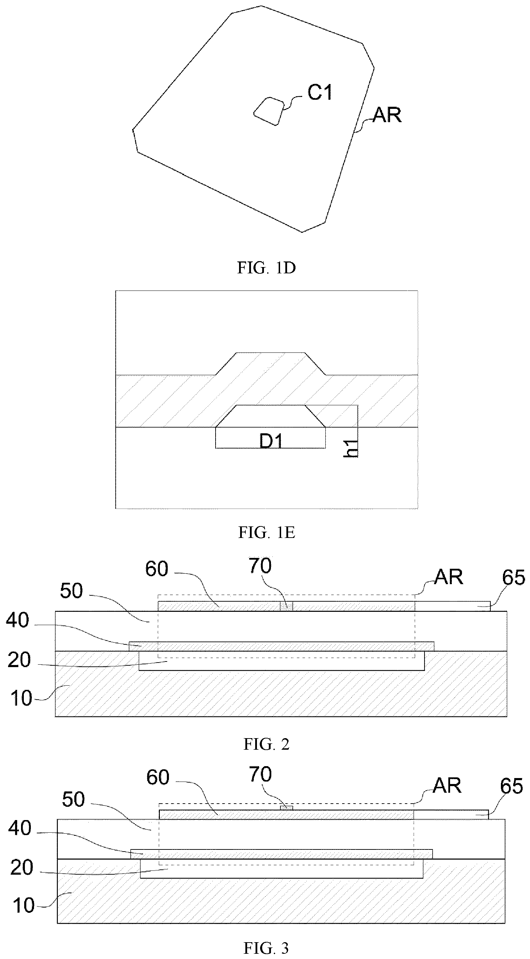

FIG. 1D is a schematic view of shapes of the central defect structure and an effective region in FIG. 1A according to a further another exemplary embodiment of the present disclosure. The shape of the central defect structure in the top view may be similar to and smaller than the shape of the effective acoustic region of the resonator. As shown in FIG. ID, the effective acoustic region AR of the resonator has an irregular polygon shape, and a defect structure C1 of the resonator has a shape similar to and smaller than the polygon shape. The shape of the defect structure C1 is scaled down in such a ratio that a length of the longest side of the defect structure C1 falls within a length range of 1 µm to 50 µm. The various top-view shapes and dimensional ranges described above are applicable to all embodiments of defect structures, which will be described later. In the present disclosure, a maximum dimension of the central defect structure is defined as a length of the longest side of the polygon shape in FIG. ID, the side length of the square shape in FIG. 1C, or the diameter of the circle shape in FIG. 1B.

FIG. 1E is a schematic dimensional view of the central defect structure in FIG. 1A according to an exemplary embodiment of the present disclosure. The void/filling portion 71 has a thickness h1 in a range of 20 Å to 20000 Å, as shown in FIG. 1E.

In the present disclosure, in the top view of the resonator, the maximum dimension of the central defect structure is in a range of 1 µm to 50 µm, or within 20% of the length of the longest side of the effective region of the polygonal resonator. Further, in the top view of the resonator, the maximum size of the central defect structure is in a range of 1 µm to 10 µm, or within 5% of the length of the longest side of the effective region of the polygonal resonator.

In the present disclosure, one of values within the numerical range may be, for example, a middle value within the numerical range or the like, except for an endpoint value (when the endpoint value is included within the numerical range) or a value adjacent to the endpoint value in the numerical range (when the endpoint value is excluded).

FIG. 2 is a schematic sectional view of a bulk acoustic wave resonator according to an exemplary embodiment A200 of the present disclosure.

The bulk acoustic wave resonator includes:
10: a substrate typically made of monocrystalline silicon, gallium arsenide, sapphire, quartz or the like;
20: an acoustic mirror which may be an air cavity in the above embodiment, and may employ a Bragg reflection layer or other equivalent acoustic reflection structures;
40(35)/60(65): a bottom electrode (pin)/a top electrode (pin) made of molybdenum, ruthenium, gold, aluminum, magnesium, tungsten, copper, titanium, iridium, osmium, chromium, or composites or alloys thereof; and
50: a piezoelectric layer film made of aluminum nitride, zinc oxide, PZT or the like and containing rare earth element doping materials with the above materials of a predetermined atomic ratio.

In the embodiment A200, a heavy metal filling portion 70 is embedded in a central region of the top electrode 60. The heavy metal filling portion 70 is made of the same material as the heavy metal filling portion in the embodiment A100. A flat region is formed by the top electrode 60 and the metal filling portion 70. This arrangement further reduces an impedance mismatch effect caused by the central defect as compared to the embodiment A100.

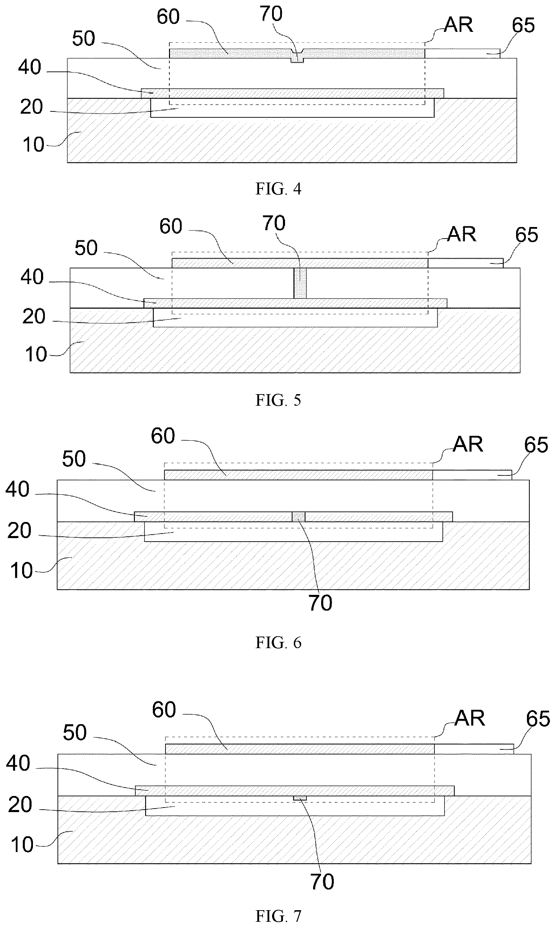

In FIG. 6, the bottom electrode has the same arrangement as the top electrode in FIG. 2, and the description thereof will be omitted herein.

FIG. 3 is a schematic sectional view of a bulk acoustic wave resonator according to an exemplary embodiment A300 of the present disclosure.

The bulk acoustic wave resonator includes:
10: a substrate typically made of monocrystalline silicon, gallium arsenide, sapphire, quartz or the like;
20: an acoustic mirror which may be an air cavity in the above embodiment, and may employ a Bragg reflection layer or other equivalent acoustic reflection structures.
40(35)/60(65): a bottom electrode (pin)/a top electrode (pin) made of molybdenum, ruthenium, gold, aluminum, magnesium, tungsten, copper, titanium, iridium, osmium, chromium, or composites or alloys thereof; and
50: a piezoelectric layer film made of aluminum nitride, zinc oxide, PZT or the like and containing rare earth element doping materials with the above materials of a predetermined atomic ratio.

In the embodiment A300, a heavy metal load portion 70 is located near a center region of an upper surface of the top electrode. This structure is manufactured only through metal deposition and etching processes after the top electrode is processed, and therefore the process is significantly simplified. The heavy metal load portion 70 may be made of the same material as the heavy metal filling portion in the embodiment A100. In FIG. 3, the heavy metal load portion corresponds to a protrusion.

Although FIG. 3 only shows the protrusion protruding upwardly from the upper surface of the top electrode, the present disclosure is not limited thereto. For example, the protrusion may protrude from a lower surface of the top electrode toward the piezoelectric layer. The bottom electrode may be provided with the protrusion. As shown in FIG. 7, the bottom electrode also has the same arrangement as that of the bottom electrode in FIG. 3, and the description thereof will be omitted herein.

FIG. 4 is a schematic sectional view of a bulk acoustic wave resonator according to an exemplary embodiment of the present disclosure.

The bulk acoustic wave resonator includes:
10: a substrate typically made of monocrystalline silicon, gallium arsenide, sapphire, quartz or the like;
20: an acoustic mirror which may be an air cavity in the above embodiment, and may employ a Bragg reflection layer or other equivalent acoustic reflection structures;
40(35)/60(65): a bottom electrode (pin)/a top electrode (pin) made of molybdenum, ruthenium, gold, aluminum, magnesium, tungsten, copper, titanium, iridium, osmium, chromium, or composites or alloys thereof; and
50: a piezoelectric layer film made of aluminum nitride, zinc oxide, PZT or the like and containing rare earth element doping materials with the above materials of a predetermined atomic ratio.

In the embodiment A400, the bulk acoustic wave resonator does not include a heavy metal structure. A defect structure is embedded in an upper surface of the piezoelectric layer 50, and the top electrode is then directly deposited on the upper surface of the piezoelectric layer. The manufacturing process of this structure is simpler than that described in the embodiment A300. Meanwhile, expensive heavy metals are unnecessary, thereby greatly reducing the cost.

FIG. 5 is a schematic sectional view of a bulk acoustic wave resonator according to an exemplary embodiment of the present disclosure.

The bulk acoustic wave resonator includes:
10: a substrate typically made of monocrystalline silicon, gallium arsenide, sapphire, quartz or the like;
20: an acoustic mirror which may be an air cavity in the above embodiment, and may employ a Bragg reflection layer or other equivalent acoustic reflection structures;
40(35)/60(65): a bottom electrode (pin)/a top electrode (pin) made of molybdenum, ruthenium, gold, aluminum, magnesium, tungsten, copper, titanium, iridium, osmium, chromium, or composites or alloys thereof; and
50: a piezoelectric layer film made of aluminum nitride, zinc oxide, PZT or the like and containing rare earth element doping materials with the above materials of a predetermined atomic ratio.

In the embodiment A500, a through hole 70 is provided in a central region of the piezoelectric layer. The through hole 70 may be filled with air or other non-piezoelectric and non-conductive materials, such as silicon dioxide, silicon nitride, silicon carbide, aluminum oxide, magnesium oxide or the like. In the embodiment A500, since a piezoelectric material is removed from the central region, heat generation in the through hole 70 can be completely eliminated.

It should be noted that the central defect structures in the above embodiments A100-400 are not limited to being formed in the top electrode, and may be symmetrically formed at a corresponding position of the bottom electrode. In this way, the top electrode and/or the bottom electrode have a defective structure as described above.

It should be noted that, in the present disclosure, a "high-temperature region" refers to a region that is centered on a center of mass of the effective region and has a radius r. The radius r is 50%, and further 20% of a radius of an equivalent circle of the effective region. Further, the equivalent circle as described above refers to a circle that is centered on the center of mass of the effective region and has an area equal to that of the effective region. In general, an energy exchange efficiency between the electric field and a sound field in the center of mass region of the resonator is largest, and so the heating power is also largest. Meanwhile, when the effective region of the resonator has a convex geometry, the center of mass region is surrounded by the surrounding substances more uniformly than other regions such that the center of mass region has the lowest heat dissipation efficiency. Hence, the center of mass of the effective region is used as a heat generation center of the resonator with the effective region of the convex geometry.

In the present disclosure, only a portion of an upper end of the support structure may be located in the high-temperature region, or the entire upper end may be located in the high-temperature region, which are both within the scope of the present disclosure.

Since the operating process of the resonator is essentially an interaction of the piezoelectric material and the field, a spatial distribution of a thermal power density of the resonator is directly related to a spatial distribution of materials in the effective region of the resonator. Further, when the resonator has the effective region of the convex geometry, the highest thermal power density is provided near the center (the center of mass) of the material distribution. Although the effective region of the resonator is composed of different materials such as the metal electrode layer and the piezoelectric layer in the thickness direction, in the top view, an equivalent areal density of the effective region can be considered to be uniform since the thickness of each material layer is usually uniform (or approximately uniform). In the above case, a plane center of mass of the effective region is located at a plane geometric center of the region.

In the present disclosure, the metal electrodes are retained in the high-temperature region, which can improve a thermal conductivity from the high-temperature region to non-high temperature region, thereby improving the heat dissipation performance of the resonator. Further, a continuity of the process layers such as the electrodes, the piezoelectric layer and the passivation layer are maintained by a metal or other fillers. Therefore, compared with a method of forming a through hole in the electrode, in the present disclosure, an acoustic impedance mismatch region is prevented from being generated in the center of the resonator, thereby greatly avoiding generation of a parasitic mode and preventing significant deterioration of important electrical parameters (such as, a Q value, an electromechanical coupling coefficient and the like) of the resonator.

In the present disclosure, the central defect region may be arranged on the top electrode, the piezoelectric layer, and the bottom electrode. Alternatively, the central defect region may be arranged at other positions, such as a passivation layer. FIGS. 8 and 9 illustrate alternative embodiments.

In FIG. 8, a reference sign 80 represents a passivation layer or other process layer (i.e., an auxiliary layer), and a reference sign 81 represents a protrusion which is made of a same or different material as that of the passivation layer and functions to change a vibration frequency of the central region of the resonator by increasing the mass load.

In FIG. 9, a reference sign 80 represents a passivation layer or other process layer (i.e., an auxiliary layer), and a reference sign 81 represents an arched structure integrated with the passivation layer. The arched structure functions to partially separate the passivation layer from the effective acoustic region to reduce the mass load of a separated region, thereby changing the resonant frequency of the local region.

In view of the above description, the present disclosure provides the following technical solutions.
1. A bulk acoustic wave resonator includes:
   a substrate;
   an acoustic mirror;
   a bottom electrode;
   a top electrode; and
   a piezoelectric layer,
   wherein:
      the acoustic mirror, the bottom electrode, the piezoelectric layer and the top electrode overlap with each other in a thickness direction of the substrate to form an overlapping region, which is an effective region of the resonator; and
      a central defect structure is provided in the effective region, and at least part of the central defect structure is located in a high-temperature region of the effective region in a top view of the resonator, wherein the high-temperature region refers to a region which is centered on a center of mass of the effective region and has a radius r, the radius r is 50% of a radius of an equivalent circle of the effective region where the high-temperature region is located, and the equivalent circle is centered on the center of mass of the effective region and has an area equal to that of the effective region.
2. A bulk acoustic wave resonator includes:
   a substrate;
   an acoustic mirror;
   a bottom electrode;
   a top electrode; and
   a piezoelectric layer,
   wherein:
      the acoustic mirror, the bottom electrode, the piezoelectric layer and the top electrode overlap with each other in a thickness direction of the substrate to form an overlapping region, which is an effective region of the resonator; and
      a central defect structure is provided in the effective region, and the central defect structure is located in at least part of a high-temperature region in a top view of the resonator, wherein the central defect structure has a thickness different from that of a layer where the central defect structure is located and/or is made of a material different from that of the layer, the high-temperature region refers to a region which is centered on a center of mass of the effective region and has a radius r, the radius r is 50% of a radius of an equivalent circle of the effective region where the high-temperature region is located, and the equivalent circle is centered on the center of mass of the effective region and has an area equal to that of the effective region.
3. A filter includes the resonator as described above.
4. An electronic device includes the resonator as described above or the filter as described above. It should be noted that the electronic device herein includes, but is not limited to, intermediate products such as a RF front-end, filter and amplifier modules, and terminal products such as mobile phones, WIFI, and drones.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
an acoustic mirror;
a bottom electrode;
a top electrode; and
a piezoelectric layer,
wherein the acoustic mirror, the bottom electrode, the piezoelectric layer and the top electrode overlap with each other in a thickness direction of the substrate to form an overlapping region, and the overlapping region is an effective region of the resonator; and
wherein a central defect structure is provided in the effective region, at least part of the central defect structure is located in a high-temperature region of the effective region in a top view of the resonator, the high-temperature region refers to a region which is centered on a center of mass of the effective region and has a radius (r), the radius (r) is 50% of a radius of an equivalent circle of the effective region where the high-temperature region is located, and the equivalent circle is centered on the center of mass of the effective region and has an area equal to an area of the effective region.

2. The resonator according to claim 1, **characterized in that** the radius (r) is 20% of an area of the equivalent circle of the effective region where the high-temperature region is located.

3. The resonator according to claim 1 or 2, **characterized in that** the central defect structure comprises an arched structure or a recessed structure integrated with the top electrode or the bottom electrode.

4. The resonator according to claim 3, **characterized in that** the arched structure is configured to form a gap between the top electrode or the bottom electrode and the piezoelectric layer, and the recessed structure is configured to form a recess on a side of the top electrode or the bottom electrode away from the piezoelectric layer.

5. The resonator according to claim 4, **characterized in that** a portion of the top electrode or the bottom electrode for forming the arched structure or the recessed structure has a thickness that is the same as thicknesses of other portions.

6. The resonator according to claim 4, **characterized in that** the gap has a thickness in a range of 20 Å to 20000 Å, or the recess has a depth in a range of 20 Å to 20000 Å.

7. The resonator according to claim 4, **characterized in that** the gap or the recess is filled with air, a dielectric material, or a metal oxide.

8. The resonator according to claim 4, **characterized in that** the gap or the recess is filled with a metal, and the metal has a density greater than a density of a material of the top electrode or the bottom electrode where the gap or the recess is located.

9. The resonator according to claim 1 or 2, **characterized in that** the central defect structure is an electrode filling structure arranged in the top electrode or the bottom electrode, and the electrode filling structure is made of a metal and the metal has a density greater than a density of a material of the top electrode or the bottom electrode.

10. The resonator according to claim 9, **characterized in that** the electrode filling structure is arranged in a through hole of the top electrode or the bottom electrode, and is flush with the electrode where the electrode filling structure is located.

11. The resonator according to claim 1 or 2, **characterized in that** the central defect structure is a metal protrusion arranged on the top electrode or the bottom electrode, and the metal protrusion protrudes from one side of the respective electrode.

12. The resonator according to claim 1 or 2, **characterized in that** the central defect structure is a piezoelectric layer filling structure arranged in the piezoelectric layer.

13. The resonator according to claim 12, **characterized in that** the piezoelectric layer filling structure at least partially extends in a thickness direction of the piezoelectric layer.

14. The resonator according to claim 13, **characterized in that** the piezoelectric layer filling structure is arranged in a through hole of the piezoelectric layer, and is connected with the top electrode and the bottom electrode.

15. The resonator according to any one of claims 12 to 14, **characterized in that** the piezoelectric layer filling structure is made of a material selected from air or a non-piezoelectric and non-conductive material.

16. The resonator according to claim 15, **characterized in that** the non-piezoelectric and non-conductive material comprises silicon dioxide, silicon nitride, silicon carbide, aluminum oxide, or magnesium oxide.

17. The resonator according to claim 1 or 2, **characterized in that** the resonator further comprises an auxiliary layer provided on the top electrode; and
the central defect structure comprises an arched structure, a recessed structure or a protruding structure integrated with the auxiliary layer, or a filling structure provided in the auxiliary layer.

18. The resonator according to any one of claims 1 to 17, **characterized in that** in a top view of the resonator, the central defect structure has a circle or square shape, or a polygonal shape similar to a shape of the effective region.

19. The resonator according to claim 18, **characterized in that** in the top view of the resonator, the central defect structure has a maximum dimension, and the maximum dimension is in a range of 1 µm to 50 µm or within 20% of a length of a longest side of the effective region of the polygonal resonator.

20. The resonator according to claim 19, **characterized in that** in the top view of the resonator, the maximum dimension of the central defect structure is in a range of 1 µm to 50 µm or within 5% of the length of the longest side of the effective region of the polygonal resonator.

21. A bulk acoustic wave resonator, comprising:
a substrate;
an acoustic mirror;
a bottom electrode;
a top electrode; and
a piezoelectric layer,
wherein the acoustic mirror, the bottom electrode, the piezoelectric layer and the top electrode overlap with each other in a thickness direction of the resonator to form an overlapping region, and the overlapping region is an effective region of the resonator; and
wherein a central defect structure is provided in the effective region, and in a top view of the resonator, the central defect structure is located in at least part of a high-temperature region, a thickness of the central defect structure is the same as or different from a thickness of a layer where the central defect structure is located and/or a material of the central defect structure is the same as or different from a material of the layer, the high-temperature region refers to a region that is centered on a center of mass of the effective region and has a radius (r), the radius (r) is 50% of a radius of an equivalent circle of the effective region where the high-temperature region is located, and the equivalent circle is centered on the center of mass of the effective region and has an area equal to an area of the effective region.

22. The resonator according to claim 21, **characterized in that** the radius (r) is 20% of the radius of the equivalent circle of the effective region where the high-temperature region is located.

23. The resonator according to claim 1 or 21, **characterized in that** the central defect region is arranged within the high-temperature region.

24. A filter, comprising the bulk acoustic wave resonator according to any one of claims 1 to 23.

25. An electronic device, comprising the bulk acoustic wave resonator according to any one of claims 1 to 23 or the filter according to claim 24.
